Europäisches Patentamt

European Patent Office

Office européen des brevets

(11) Numéro de publication: **0 364 347**
**A1**

(12) ## DEMANDE DE BREVET EUROPEEN

(21) Numéro de dépôt: 89402769.7

(22) Date de dépôt: 09.10.89

(51) Int. Cl.5: **H01L 31/024 , H01L 31/02 , G01J 5/06 , F25D 19/00**

(30) Priorité: 13.10.88 FR 8813470

(43) Date de publication de la demande:
18.04.90 **Bulletin 90/16**

(84) Etats contractants désignés:
**DE GB IT**

(71) Demandeur: **SAT (SOCIETE ANONYME DE TELECOMMUNICATIONS) Société Anonyme française**
**41, rue Cantagrel**
**F-75631 Paris Cédex 13(FR)**

(72) Inventeur: **Ic, André**
**12 rue Larrey**
**F-75005 Paris(FR)**
Inventeur: **Crestey, Pierre**
**5 rue des Cèdres**
**F-86000 Biard(FR)**
Inventeur: **Pele, Michel**
**2 rue des Grands Chênes**
**F-86280 Saint-Benoit(FR)**
Inventeur: **Rouquier, Pierre**
**11 rue Jean de la Bruyère**
**F-78000 Versailles(FR)**

(74) Mandataire: **Bloch, Gérard et al**
**2, square de l'Avenue du Bois**
**F-75116 Paris(FR)**

(54) **Dispositif cryostatique pour détecteur de rayonnements.**

(57) Le détecteur (1) est disposé à l'extrémité d'un doigt (2) refroidi. Une enveloppe (3), transparente aux rayonnements à détecter, au moins au voisinage du détecteur (1), forme autour du doigt (2) et du détecteur (1) une enceinte (4) d'isolation thermique. Un circuit électrique (5) amène le ou les signaux détectés à l'extérieur de l'enceinte, et immobilise radialement l'extrémité du doigt (2) par rapport à ladite enveloppe (3), du fait que son substrat est un disque solidaire à la fois de ladite enveloppe (3) et de l'extrémité du doigt (2).

L'invention s'applique aux détecteurs infra-rouges, par exemple.

FIG.1

## Dispositif cryostatique pour détecteur de rayonnements

La présente invention a pour objet un dispositif cryostatique pour détecteur de rayonnements comprenant :
- un doigt, refroidi et pourvu d'une extrémité portant au moins un détecteur de rayonnements délivrant un signal détecté,
- une enveloppe, entourant ledit doigt et ledit détecteur, et transparente auxdits rayonnements au moins au voisinage dudit détecteur, pour former autour dudit doigt et dudit détecteur une enceinte d'isolation thermique, et,
- un circuit électrique, pour amener ledit signal détecté à l'extérieur de ladite enceinte.

Un tel dispositif permet de maintenir à une température convenable, très basse, un détecteur ou une mosaïque de détecteurs de rayonnements, par exemple des détecteurs infra-rouges. En effet, ces détecteurs sont réalisés dans des matériaux semi-conducteurs qui, pour avoir de bonnes performances de détection, doivant être portés à très basse température.

Un tel dispositif s'applique notamment aux caméras et autodirecteurs infra-rouges.

On connaît déjà des dispositifs du type défini ci-dessus, notamment par les demandes FR-2 530 382, et les demandes FR-2 256 385. Ces dispositifs présentent toutefois les inconvénients suivants. Lorsqu'ils sont soumis à un niveau de vibrations élevé, il apparaît des instabilités dans l'image obtenue à partir des signaux détectés et traités et de plus, des signaux de bruit parasite viennent parfois se superposer aux signaux détectés, et ceci de façon aléatoire, ce qui dégrade la qualité de l'image obtenue.

Le présente invention vise à pallier les inconvénients précédents.

A cet effet, elle a pour objet un dispositif du type défini ci-dessus, caractérisé par le fait que ledit circuit électrique comprend :
- un disque, réalisé dans un matériau isolant électrique, s'étendant dans un plan perpendiculaire à l'axe dudit doigt, pourvu d'une partie centrale solidaire de ladite extrémité du doigt, et d'une partie périphérique solidaire de ladite enveloppe et qui la traverse, pour immobiliser radialement ladite extrémité du doigt par rapport à ladite enveloppe et,
- une pluralité de conducteurs supportés par ledit disque.

Avec le dispositif de l'invention, l'image obtenue est stable, même lorsque le dispositif est embarqué à bord d'un char, par exemple. Ce résultat remarquable a été obtenu par la demanderesse car elle a pensé que l'origine des instabilités de l'image observées dans ce cas était à rechercher dans le fait que le doigt, solidaire par sa base du reste du char, était susceptible d'entrer en résonance mécanique, à la manière d'une poutre vibrante encastrée, sous l'effet des excitations vibratoires dues au déplacement du char. Dans le dispositif de l'invention, le doigt ne peut entrer en résonance mécanique, car son extrémité est radialement solidaire de l'enveloppe, qui est dimensionnée pour rester toujours immobile relativement au corps du char. Le doigt se trouve donc également immobilisé par rapport au corps du char, et l'image obtenue est stable.

De plus, il n'apparaît plus de bruit parasite superposé aux signaux détectés. Cet autre résultat remarquable a été obtenu par la demanderesse du fait qu'elle a observé que, ce bruit n'apparaissant que pour certaines valeurs de la fréquence d'excitation mécanique, il était certainement lié aux vibrations mécaniques subies par le circuit d'amenée du ou des signaux détectés.

Dans la présente invention, du fait que ce circuit, en plus de sa fonction d'amenée du ou des signaux détectés, a pour fonction la liaison mécanique entre l'extrémité du doigt et l'enveloppe, il n'est pas libre de se déplacer comme dans certains dispositifs de l'art antérieur, et il en résulte une réduction du bruit électrique.

Certes, on connaît, par la demande EP-A-0 058 645, un dispositif dans lequel les conducteurs d'amenée des signaux électriques s'opposent, dans une certaine mesure, aux déplacements de l'extrémité du doigt. Dans ce dispositif, le circuit électrique comprend un substrat annulaire solidaire de l'enveloppe et qui la traverse, et que porte une pluralité de broches perpendiculaires au substrat et reliées électriquement au détecteur par des fils fins. Cependant, l'immobilisation de l'extrémité du doigt apportée par une telle structure est imparfaite, dans la mesure où les broches peuvent ployer sous l'action de contraintes élevées, autorisant ainsi un déplacement de l'extrémité du doigt. De plus, les fils fins qui relient les broches au détecteur risquent alors de se rompre.

Dans la présente invention, la caractéristique selon laquelle le substrat du circuit conducteur est un disque dont la partie centrale est solidaire de l'extrémité du doigt est particulièrement intéressante, du fait qu'elle permet d'immobiliser de façon efficace l'extrémité du doigt relativement à l'enveloppe, tout en permettant d'utiliser un disque d'épaisseur faible, ce qui permet d'augmenter la résistance thermique entre l'extrémité du doigt et l'enveloppe, afin d'éviter le réchauffement du doigt par apport de chaleur en provenance de l'enveloppe, par l'intermédiaire du disque.

Avantageusement encore, ledit matériau est rigide et ledit disque est pourvu d'une pluralité de fentes, s'étendant le long d'arcs de cercles concentriques centrés sur le centre dudit disque, et disposées pour former des chicanes s'opposant aux échanges thermiques entre ladite partie centrale et ladite partie périphérique.

Les chicanes augmentent encore la résistance thermique du disque, pour conférer à l'ensemble un excellent comportement thermique. De plus, la rigidité du support permet d'assurer une immobilité quasi-parfaite des conducteurs, même lorsque le dispositif est soumis à des excitations mécaniques importantes, ce qui réduit encore le bruit électrique. De plus, la structure des fentes du disque rend celui-ci déformable dans la direction de l'axe du doigt, ce qui permet de tolérer une disparité dans les variations de longueur du doigt et de l'enveloppe, lorsque la température varie.

Avantageusement encore ledit disque est réalisé dans un matériau choisi parmi les matériaux suivants : zircone, verre, quartz, forsterite, céramique, et vitrocéramique de type MACOR (marque déposée).

Ces matériaux ont de faibles conductivités thermiques, ce qui contribue à l'augmentation de la résistance thermique.

La présente invention sera mieux comprise grâce à la description suivante de la forme de réalisation préférée du dispositif de l'invention, et de quelques variantes, faite en se référant aux dessins annexés, sur lesquels :

- la figure 1 représente une vue en coupe du dispositif cryostatique de l'invention,

- la figure 2 représente une vue de dessus du circuit électrique du dispositif de la figure 1,

- la figure 3 représente une vue de dessus d'une variante du circuit électrique de la figure 2, et,

- la figure 4 représente une coupe partielle d'une variante du dispositif de la figure 1.

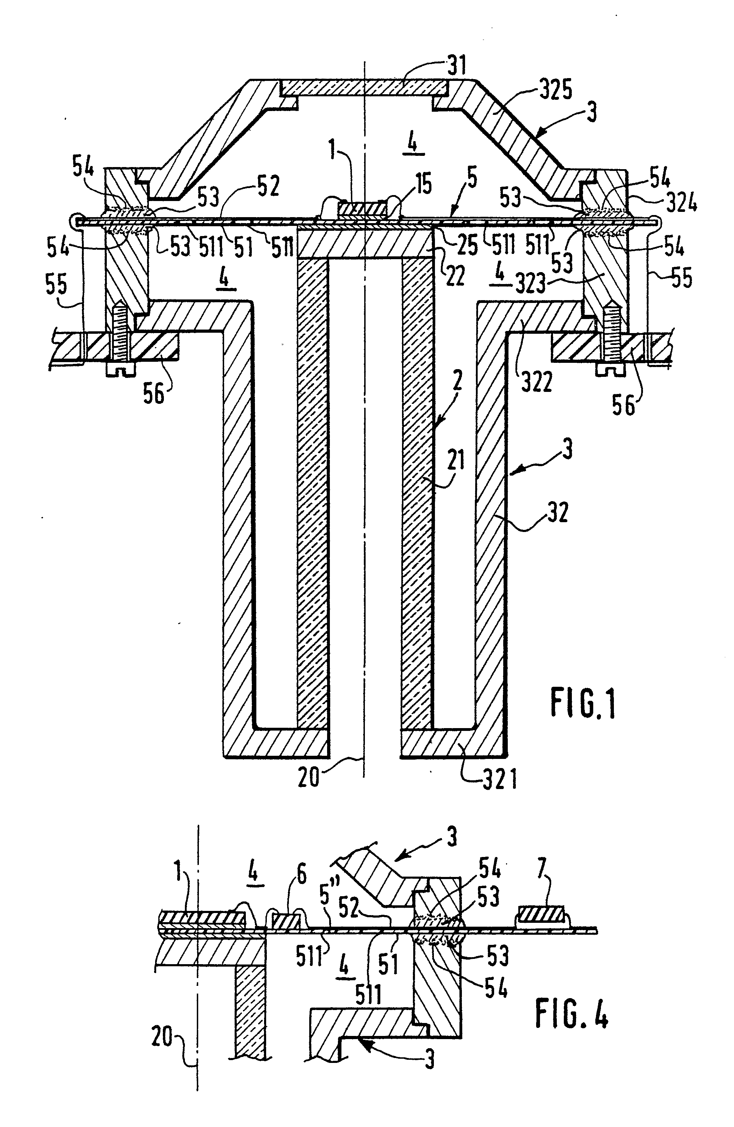

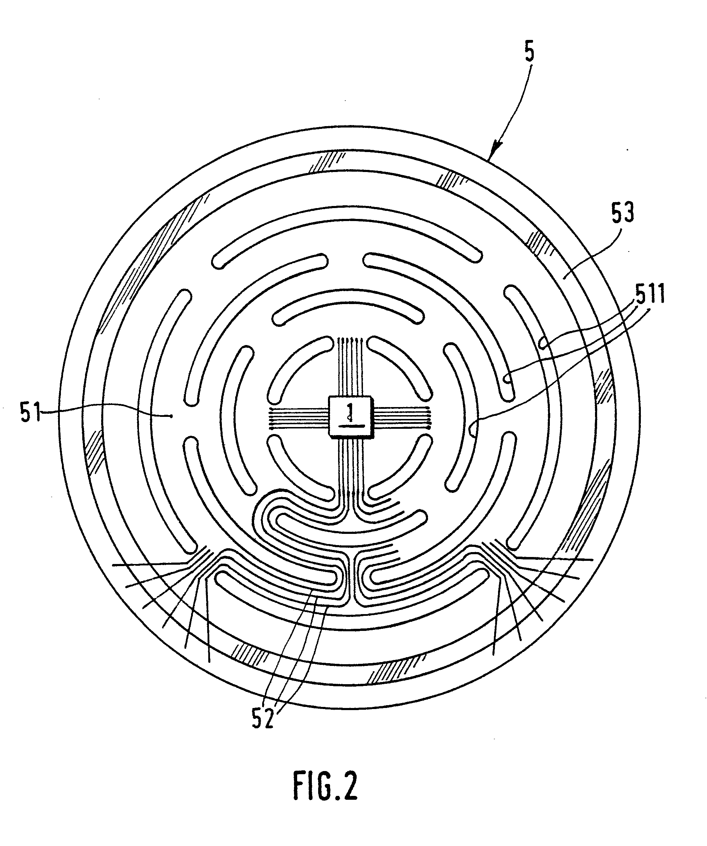

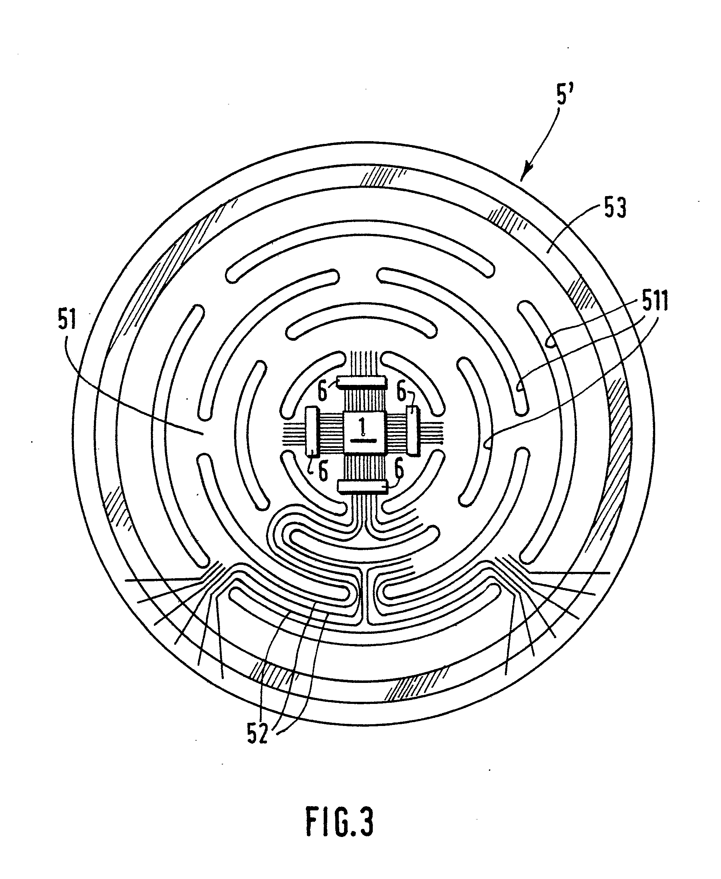

En se référant à la figure 1, un dispositif cryostatique pour détecteur de rayonnements, ici une mosaïque 1 de détecteurs infra-rouges, est maintenant décrit.

Comme cela est connu, une mosaïque de détecteurs infra-rouges du type de la mosaïque 1, utilisée par exemple dans une caméra infra-rouge, doit être refroidie à une température très basse, par exemple à la température de l'azote liquide, pour fonctionner de façon satisfaisante.

A cet effet, la mosaïque 1 est disposée à l'extrémité d'un doigt 2 de refroidissement. Le doigt 2 de refroidissement est un doigt creux à l'intérieur duquel est disposée une source de froid non représentée. De façon connue, la source de froid est soit un liquide cryogénique, soit un cryogénérateur, par exemple à détente Joule-Thomson, soit encore un thermoélément à effet Peltier. Le doigt s'étend ici le long d'un axe 20.

Le doigt 2, portant donc à son extrémité la mosaïque 1 de détecteurs, est entouré par une enveloppe 3, qui forme, autour du doigt 2 et de la mosaïque 1, une enceinte 4 d'isolation thermique, mise sous vide, ou remplie d'un gaz de faible conductivité thermique.

L'enceinte 3 est pourvue, dans la zone voisine de la mosaïque 1 de détecteurs, d'une fenêtre 31 transparente aux rayonnements infra-rouges à détecter, par exemple en germanium ou en verre spécial.

En réponse aux rayonnements infra-rouges qu'ils reçoivent à travers la fenêtre 31, chacun des détecteurs de la mosaïque 1 délivre un signal électrique, ou signal détecté. Les signaux détectés sont amenés à l'extérieur de l'enceinte 4 par un circuit électrique 5.

Le circuit électrique 5 est ici un circuit imprimé, qui comprend, comme le montre la figure 2, un disque 51 isolant électrique qui supporte une pluralité de pistes conductrices, ou conducteurs électriques 52. Comme cela apparaît sur la figure 1, le disque 51 s'étend dans un plan perpendiculaire à l'axe 20 dudit doigt.

La partie centrale du disque 51 est rendue solidaire de l'extrémité du doigt 2 par collage, ou scellement, à l'aide d'un matériau, à coefficient de dilatation compatible avec celui du doigt, formant une couche 25. Le mosaïque 1 de détecteurs est collée par une couche de colle 15, sur la face libre de la partie centrale du disque 51 disposée en regard de l'extrémité du doigt 2, de façon à ce que les détecteurs se trouvent convenablement refroidis. Les sorties de chacun des détecteurs sont reliées aux conducteurs 52, par exemple par des liaisons réalisées, de façon connue, par thermocompression.

La partie périphérique du disque 51 traverse l'enveloppe 3, dont elle est rendue solidaire d'une façon qui sera expliquée dans la suite. Ainsi, les conducteurs 52 sont disponibles à l'extérieur de l'enceinte 4.

Le disque 51 est pourvu d'une pluralité de fentes 511. Les fentes 511 s'étendent le long d'arcs de cercles concentriques centrés sur le centre du disque 51, et forment des chicanes, de telle sorte que tout trajet entre la partie centrale et la partie périphérique du disque, et empruntant le matériau du disque, est un trajet en méandres aussi long que possible, ce trajet étant d'ailleurs identique à celui suivi par les conducteurs 52, qui s'étendent également de la partie centrale à la partie périphérique du disque, comme le montre la figure 2.

Ici, quatre fentes 511 identiques et de longueur légèrement inférieure à un quart de cercle sont disposées sur chacun des cercles concentriques, et les quatre parties pleines entre les quatre fentes identiques sont décalées de 45° d'un cercle à l'autre.

Les fentes 511 ont une triple fonction :
- premièrement, elles s'opposent aux échanges thermiques entre la partie centrale et la partie périphérique du disque 51, du fait qu'elles allongent les trajets dans la matériau du disque,
- deuxièmement, elles confèrent au disque 51, même si celui-ci est réalisé dans un matériau rigide, une déformabilité compatible avec une différence de comportement en température du doigt 2 et de l'enceinte 3, en particulier dans la direction définie par l'axe 20, et,
- troisièmement, elle permettent la communication des deux portions de la cavité 4 situées de part et d'autre du disque 51, pour une bonne homogénéité du vide, ou, le cas échéant, du contenu gazeux de ces deux portions.

Le doigt 2 comprend ici un corps 21, en forme de cylindre circulaire creux d'aux 20. Le corps 21 est ici en verre. Sont extrémité supérieure, sur la figure 1, qui correspond à l'extrémité du doigt 2, est fermée par un disque métallique 22, sur laquelle est fixé le disque 51, comme cela a déjà été mentionné.

L'enveloppe 3 comprend ici un corps 32 sensiblement en forme de cylindre circulaire creux d'axe 20, de diamètre supérieur à celui du corps 21 et disposé autour de celui-ci. L'extrémité inférieure, sur la figure 1, du corps 32 comprend un bord 321 s'étendant dans un plan de section droite, pour se rapprocher de l'axe 20 et se raccorder à l'extrémité inférieure, sur la figure 1, du corps 21, c'est-à-dire à la base du doigt 2. L'extrémité supérieure, sur la figure 1, du corps 32 comprend un bord 322 s'étendant dans un plan de section droite, pour s'éloigner de l'axe 20.

Une première paroi 323, en forme de cylindre circulaire creux d'axe 20, de diamètre supérieur à celui du corps 32, est raccordée au bord 322. La paroi 323 est réalisée dans un alliage métallique à coefficient de dilatation en température voisin de celui du verre, par exemple l'alliage de nickel, cobalt et fer connu sous le nom de DILVER P (marque déposée).

Le hauteur de la paroi 323 est telle que la partie périphérique du disque 51 vient en appui sur le bord supérieur, sur la figure 1, de la paroi 323. Dans la zone d'appui, chaque face du disque 51 est revêtue d'une couche de verre 53, et la couche de verre 53 de la face inférieure, sur la figure 1, est soudée à la paroi 323 par une soudure verre-métal 54.

Une deuxième paroi 324, en forme de cylindre circulaire d'axe 20, de même diamètre que la paroi 323, et réalisée dans le même matériau, vient en appui sur la couche de verre 53 de la face supérieure, sur la figure 1, du disque 51 et son bord inférieur, sur la figure 1, est soudé à cette couche de verre 53 par une soudure verre-métal 54.

Une paroi métallique 325, sensiblement en forme de tronc de cône d'axe 20, permet le raccordement de la deuxième paroi 324 et de la fenêtre 31, s'étendant dans un plan perpendiculaire à l'axe 20.

Naturellement, les différentes pièces qui ont été décrites sont assemblées entre elles de façon connue pour que l'enceinte 4 soit hermétique. On utilise par exemple une fermeture au laser pour les assemblages métal-métal, et des soudures pour les assemblages verre-métal. Il est prévu un queusot non représenté pour faire le vide, et, le cas échéant, remplir l'enceinte 4 d'un gaz à faible conductivité thermique.

Le disque 51 est ici réalisé en oxyde de zirconium, ou zircone.

Ce matériau est un matériau rigide isolant électriquement, et qui présente une faible conductivité thermique aux très basses températures de fonctionnement des détecteurs infra-rouges.

La disque 51 a une épaisseur de quelques dizièmes de millimètre, et les pistes conductrices 52 sont réalisées en platine, ou en or.

Après dépôt d'une couche de platine ou d'or sur le disque 51, par exemple par évaporation, les pistes conductrices 52 sont gravées, par exemple au laser, et les couches 53, réalisées en verre à bas point de fusion, sont déposées. Les couches de verre 53 ont ici une épaisseur inférieure à un millimètre.

Pour le matériau du disque, on peut utiliser également du verre, du quartz, de la forsterite, de la céramique, une vitrocéramique comme le MACOR (marque déposée), ou, d'une manière générale, tout matériau isolant électrique et présentant une faible conductivité thermique aux très basses températures. Par faible conductivité thermique, on entend ici une conductivité thermique inférieure à sensiblement :
$$5 \ 10^{-3} \text{ cal.cm / s/cm}^2 \text{.°C}$$

Lorsque l'on souhaite pratiquer dans le disque 51 des fentes comme les fentes 511, il est préférable d'utiliser un matériau rigide.

Sur la figure 1, on a représenté un circuit 5 dont la seule fonction électrique est d'amener hors de l'enceinte 4 les signaux détectés par les détecteurs 1. Comme cela est représenté sur cette figure, des conducteurs 55 relient les pistes 52 à des composants électroniques de traitement non représentés disposés sur un ou plusieurs circuits imprimés 56 de type conventionnel.

Ceci n'est pas obligatoire, et comme le montre la figure 3, une variante 5' du circuit 5 est prévue pour supporter des composants électroniques 6, disposés à l'intérieur de l'enceinte 4. Ces composants peuvent être des circuits de traitement des signaux détectés, par exemple de préamplification, d'amplification, de filtrage, de stockage ou de multiplexage pour réduire le nombre de conducteurs électriques 52, dans le cas où la mosaïque 1 comprend un très grand nombre d'éléments. Il est évidemment à la portée de l'homme du métier de déterminer l'implantation optimale de chacun de ces composants, notamment en ce qui concerne leur distance de la mosaïque 1, compte tenu de leur fonction, leur rendement à froid, ainsi que leur dissipation thermique.

Comme le montre la figure 4, une variante 5" de circuit 5' est prévue pour supporter également des composants 7, disposés à l'extérieur de l'enceinte 4.

Il est aussi possible que certains des composants 6 soient des coupleurs électro-optiques, afin de remplacer, en totalité ou en partie, les conducteurs électriques 52 par des conducteurs optiques, ou fibres optiques. Les avantages apportés par les fibres optiques sont bien connus :
immunité aux perturbations électro-magnétiques, débit d'information élevés, souplesse mécanique, taux d'atténuation faible, ce qui, dans certains cas, permet de disposer la partie électronique de traitement à distance de l'enceinte cryostatique.

Dans la description qui vient d'être faite, la mosaïque 1 de détecteurs est collée sur le disque 51, qui se trouve lue-même fixé sur l'extrémité du doigt 2. Il est également possible, afin d'améliorer le transfert thermique entre le doigt 2 et la mosaïque 1, de ménager un évidement dans la partie centrale du disque 51, de façon à ce que la mosaïque 1 soit collée directement sur le doigt 2.

**Revendications**

1. Dispositif cryostatique pour détecteur de rayonnements comprenant :
- un doigt (2), refroidi et pourvu d'une extrémité portant au moins un détecteur (1) de rayonnements délivrant un signal détecté,
- une enveloppe (3), entourant ledit doigt (2) et ledit détecteur (1), et transparente auxdits rayonnements au moins au voisinage dudit détecteur (1), pour former autour dudit doigt (2) et dudit détecteur (1) une enceinte (4) d'isolation thermique, et,
- un circuit électrique (5; 5'; 5"), pour amener ledit signal détecté à l'extérieur de ladite enceinte (4),
dispositif caractérisé par le fait que ledit circuit électrique (5; 5'; 5") comprend :
- un disque (51), réalisé dans un matériau isolant électrique, s'étendant dans un plan perpendiculaire à l'axe (20) dudit doigt (2), pourvu d'une partie centrale solidaire de ladite extrémité du doigt (2), et d'une partie périphérique solidaire de ladite enveloppe (3) et qui la traverse, pour immobiliser radialement ladite extrémité du doigt (2) par rapport à ladite enveloppe (3), et,
- une pluralité de conducteurs (52) supportés par ledit disque (51).

2. Dispositif selon la revendication 1, dans lequel ledit matériau est rigide et ledit disque (51) est pourvu d'une pluralité de fentes (511), s'étendant le long d'arcs de cercles concentriques centrés sur le centre dudit disque (51), et disposées pour former des chicanes s'opposant aux échanges thermiques entre ladite partie centrale et ladite partie périphérique.

3. Dispositif selon l'une des revendications 1 ou 2, dans lequel ledit disque (51) est réalisé dans un matériau choisi parmi les matériaux suivants : zircone, verre quartz, forsterite, céramique, et vitrocéramique de type MACOR (marque déposée).

4. Dispositif selon l'une des revendications 1 à 3, dans lequel :
- une couche de verre (53) est disposée sur chaque face du disque (51), au moins dans ladite partie périphérique,
- ladite enveloppe (3) est réalisée dans un alliage métallique à coefficient de dilatation en température voisin de celui du verre, au moins dans la zone où ladite partie périphérique la traverse, et,
- ladite couche de verre (53) est soudée à ladite enveloppe (3).

5. Dispositif selon l'une des revendications 1 à 4, dans lequel des composants électroniques (6) pour le traitement du signal détecté sont disposés sur ledit disque (51), à l'intérieur de ladite enceinte (4).

6. Dispositif selon la revendication 5, dans lequel lesdits composants électroniques (6) comprennent des coupleurs électro-optiques, et lesdits conducteurs (52) comprennent des conducteurs optiques.

7. Dispositif selon l'une des revendications 1 à 6, dans lequel des composants électroniques (7) pour le traitement du signal détecté sont disposés sur ledit disque (51), à l'extérieur de ladite enceinte (4).

8. Dispositif selon l'une des revendications 1 à 7 dans lequel un évidement est ménagé dans ladite partie centrale du disque (51), de façon à ce que ledit détecteur (1) soit collé directement sur ledit doigt (2).

FIG.1

FIG.4

FIG.2

FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | EP-A-0 058 645  (SELENIA INUDSTRIE ELETTRONICHE ASSOCIATE S.p.A.)<br>* Page 4, ligne 20 - page 7, ligne 26; revendications; figures 1-4 *<br>--- | 1,3 | H 01 L   31/024<br>H 01 L   31/02<br>G 01 J    5/06<br>F 25 D   19/00 |
| X | WO-A-8 804 037  (SANTA BARBARA RESEARCH CENTER)<br>* Page 3, ligne 19 - page 6, ligne 19; figures 1,2 * | 1 | |
| A | --- | 8 | |
| A | US-A-4 324 104  (S.B. HORN et al.)<br>* En entier *<br>--- | 1,3 | |
| A | US-A-4 501 131  (V.R. GASKIN et al.)<br>* En entier *<br>--- | | |
| A | PATENT ABSTRACTS OF JAPAN, vol. 3, no. 82 (E-123), 14 juillet 1979, page 105 E 123; & JP-A-54 60 982 (TOKYO SHIBAURA DENKI K.K.) 16-05-1979<br>* En entier *<br>--- | 1 | **DOMAINES TECHNIQUES RECHERCHES (Int. Cl.5)** |
| A | EP-A-0 213 421  (HONEYWELL INC.)<br>* Page 9, ligne 5 - page 17, ligne 4; figures 1,2 *<br>----- | 1,4 | H 01 L<br>G 01 J<br>F 25 D |

Le présent rapport a été établi pour toutes les revendications

| Lieu de la recherche | Date d'achèvement de la recherche | Examinateur |
|---|---|---|
| LA HAYE | 08-01-1990 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................
& : membre de la même famille, document correspondant

EPO FORM 1503 03.82 (P0402)